Europäisches Patentamt

European Patent Office

Office européen des brevets

(19)

(11) Veröffentlichungsnummer: **0 469 173 A1**

## (12) EUROPÄISCHE PATENTANMELDUNG

(21) Anmeldenummer: **90114825.4**

(22) Anmeldetag: **02.08.90**

(51) Int. Cl.5: **H03K 17/08**, H02M 7/515

(43) Veröffentlichungstag der Anmeldung:
**05.02.92 Patentblatt 92/06**

(84) Benannte Vertragsstaaten:
**AT BE CH DE DK ES FR GB GR IT LI LU NL SE**

(71) Anmelder: **ASEA BROWN BOVERI AG**

**CH-5401 Baden(CH)**

(72) Erfinder: **Grüning, Horst, Dr.**
**Im Ergel 10**
**CH-5404 Baden(CH)**

(54) Inverter mit Ueberstromschutz.

(57) In einem Inverter ist eine Halbbrücke modulmässig in zwei Viertelbrückenzweige aufgeteilt. In diesen sind ein über ein Gate abschaltbares Halbleiterbauelement (7, 8), eine bezüglich eines Mittelpunktes gegenüberliegende Freilaufdiode (9, 10) und ein Abblock-Kondensator (11, 12) parallel zu Freilaufdiode (9, 10) und abschaltbarem Halbleiterbauelement (7, 8) angeordnet. Zwischen einem Lastanschluss (3) der Brückenschaltung und den Mittelpunkten der Viertelbrückenzweige sind ein Messwiderstand (R1, R2) und ein strombegrenzendes Element (L1, L2) vorgesehen. Mit dem Messwiderständen kann der Laststrom transientenfrei ermittelt werden.

## Technisches Gebiet

Die Erfindung betrifft einen Inverter mit Ueberstromschutz, bei welchem zwischen einer positiven und einer negativen Versorgungsleitung im Sinn einer Halbbrückenschaltung mindestens zwei abschaltbare Halbleiterbauelemente vorgesehen sind.

## Stand der Technik

Beim Einsatz von Hochleistungs-Halbleiterbauelementen, z.B. in Inverterschaltungen, ist eine schnelle und möglichst transientenfreie Stromerfassung von eminenter Bedeutung, wenn es darum geht, auf schaltungsexterne Kurzschlüsse oder auf versehentliche Durchzündungen richtig und rechtzeitig reagieren zu können. In IGBT-Schaltungen beispielsweise ist es damit möglich, die Leistungsschalter bereits nach kurzer Zeit im Sättigungsbetrieb zu sperren. IGBTs lassen sich auch besser nützen, wenn man sie nicht mehr so schwach ansteuern muss, dass sie dem Sättigungsbetrieb für eine gewisse Zeit standhalten können.

Elemente mit beidseitiger Injektion (GTO, FSGTO, FCTh, SITh, MCT etc.) können in einem niederinduktiven Versorgungskreis nur dann vor der Zerstörung geschützt werden, wenn es gelingt, sie vor Erreichen ihres maximalen Abschaltstroms zu blockieren.

## Darstellung der Erfindung

Aufgabe der Erfindung ist es nun, einen Inverter der eingangs genannten Art anzugeben, der - im Hinblick auf eine hohe Betriebssicherheit - mit Mitteln zur Ueberwachung der Belastung der abschaltbaren Halbleiterbauelemente ausgestattet ist.

Erfindungsgemäss besteht die Lösung darin, dass

a) die Halbbrückenschaltung in zwei Viertelbrückenzweige aufgeteilt ist, in welchen dem Halbleiterbauelement bezüglich eines Mittelpunktes gegenüberliegend mindestens eine Freilaufdiode vorgesehen ist,

b) zwischen einem Lastanschluss und den Mittelpunkten jeweils ein strombegrenzendes Element angeordnet ist und

c) Mittel zum Messen des je vom Mittelpunkt zum Lastanschluss fliessenden Stromes vorgesehen sind zwecks Durchzündschutz und Detektion eines Lastkurzschlusses.

Die genannten Mittel zum Messen des Stroms können z.B. einen Messwiderstand in Serie zum strombegrenzenden Element umfassen. Es ist aber auch möglich, den Strom durch Integration der Spannungsänderung an einer Induktivität zu ermitteln. Der detektierte Strom wird an eine Regelschaltung weitergeleitet, welche gegebenenfalls das Halbleiterbauelement ausschaaltet.

Der Kern der Erfindung besteht darin, dass der Strom mit einfachen Mitteln unmittelbar im Lastanschluss (wo er weitgehend transientenfrei ist) detektiert wird und dass eine Induktivität in Serie dazu im Fall eines Fehlers die Stromanstiegsgeschwindigkeit begrenzt, so dass genügend Zeit zum Reagieren verbleibt. Weil die beim Schalten des Halbleiterbauelements auftretenden Kommutierungsströme nicht durch das stromdetektierende Element (z.B. den Messwiderstand) fliessen können, bleiben auch die unerwünschten Ueberspannungen aus.

Aus den soeben genannten Vorteilen und der Tatsache, dass der Strom zu jeder Zeit zuverlässig ermittelt werden kann, ergibt sich, dass die erfindungsgemässe Strommessung zusätzlich auch unmittelbar für die Regelung eines (vom Inverter gespeisten) Antriebs verwendet werden kann. Der erfindungsgemässe Messwiderstand nimmt somit eine Doppelfunktion wahr.

Besonders vorteilhaft ist es, wenn die abschaltbaren Halbleiterbauelemente in den Viertelbrückenzweigen komplementäre Halbleiterbauelemente sind, weil dann die Messwiderstände und die Gate-Units im wesentlichen auf dem selben Potential sind.

Zum Vermeiden von Spannungsspitzen und Erreichen einer schnellen Ansteuerung sind die abschaltbaren Halbleiterbauelemente niederinduktiv über je eine Gate-Unit angesteuert.

Wenn Mittel vorhanden sind, um einen Laststrom über die an den Messwiderständen anliegenden Spannungen zu ermitteln und an eine Regelschaltung weiterzuleiten, dann wird die im Inverter integrierte Strommessung gleich doppelt genutzt. Aufwendige externe Stromsensoren (wie sie sonst bei Antriebsregelungen unerlässlich sind) können entfallen.

Um ausser einem externen Kurzschluss auch ein Fehlzünden eines Halbleiterbauelements detektieren zu können, ist für jedes Halbleiterbauelement eines Viertelbrückenzweiges eine separate Induktivität vorzusehen.

Bevorzugterweise sind die Viertelbrückenzweige als getrennte LS- und HS-Module ausgebildet. Auf diese Weise lassen sich die Vorteile der Erfindung mit denjenigen der Schweizerischen Patentanmeldung CH-2106/90 verbinden.

Wegen ihrer Fähigkeit, grosse Ströme verarbeiten und mit hoher Geschwindigkeit schalten zu können, sind als abschaltbare Halbleiterbauelemente der FCTh und der CFCTh besonders hervorzuheben. Bei der Erfindung ist der FCTh in einem als HS-Zweig ausgebildeten Viertelbrückenzweig mit seiner Anode direkt an die positive Versorgungsleitung und der CFCTh in einem als LS-Zweig ausgebildeten Viertelbrückenzweig mit seiner Kathode direkt an die negative Versorgungsleitung angeschlossen.

Als strombegrenzendes Element eignet sich insbesondere entweder eine die Stromanstiegsgeschwindigkeit begrenzende Induktivität oder ein PTC-Element.

Im einzelnen kann die erfindungsgemässe Schaltung wie folgt ausgebildet sein: In den Viertelbrückenzweigen ist jeweils parallel zur Serieschaltung von Halbleiterbauelement und Freilaufdiode ein niederinduktiver Abblockkondensator zum Auffangen der Reverse Recovery Stromspitzen der Diode vorgesehen. Freilaufdiode und Abblockkondensator sind niederinduktiv und räumlich unmittelbar neben dem Halbleiterbauelement angeordnet. Die Leistungsschalter des Inverters werden von einer Gate-Unit in an sich bekannter Weise angesteuert.

Den bevorzugten Induktivitäten kann insofern eine Doppelfunktion zukommen, als sie Teil eines Filters zur Dämpfung des Spannungsanstiegs dV/dt im Lastkreis sein können.

Weitere Vorteile und Ausführungsformen ergeben sich aus der nachfolgenden Beschreibung.

**Kurze Beschreibung der Zeichnungen**

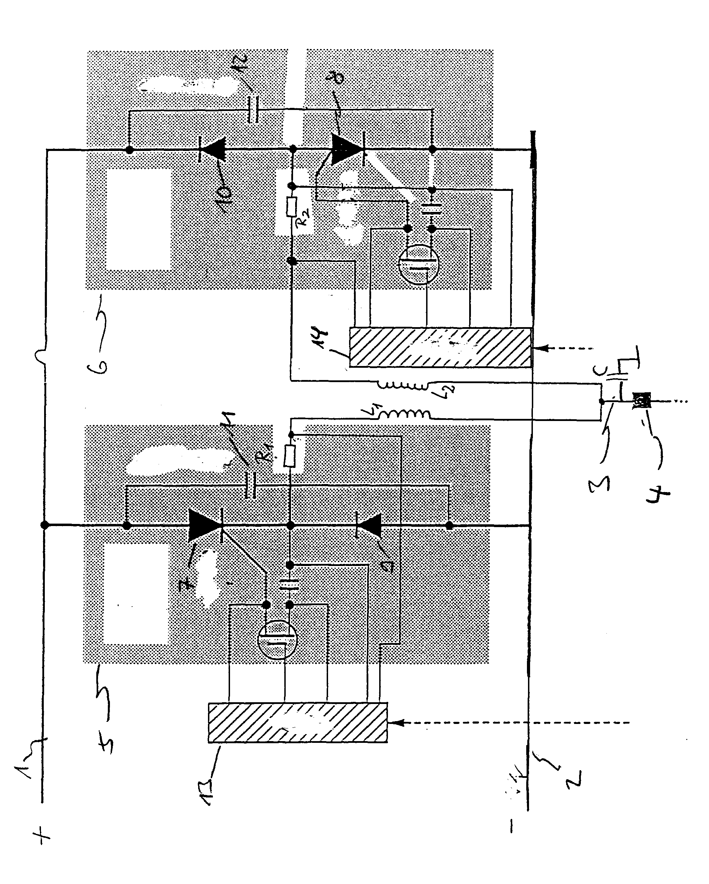

Nachfolgend soll die Erfindung anhand von Ausführungsbeispielen und im Zusammenhang mit der Zeichnung näher erläutert werden. Die einzige Figur zeigt eine Schaltanordnung eines erfindungsgemässen Inverters mit Ueberstromschutz.

**Wege zur Ausführung der Erfindung**

Die einzige Figur zeigt ein Ausführungsbeispiel einer erfindungsgemässen Inverterschaltung. Die Eingangsseite der Schaltung wird durch eine positive und eine negative Versorgungsleitung 1 resp. 2 gebildet. Auf der Ausgangsseite steht ein Lastanschluss 3 zur Verfügung, an welchem z.B. eine der drei von einem Drehstrommotor benötigten Phasen (bildlich dargestellt durch Last 4) abgegeben wird.

Die in der Figur gezeigte Halbbrücke ist aufgeteilt in zwei Viertelbrückenzweige. Jeder der beiden weist ein abschaltbares Halbleiterbauelement 7, 8, eine bezüglich eines Mittelpunktes (an dem der Lastanschluss 3 hängt) gegenüberliegende Freilaufdiode 9, 10 und einen Abblockkondensator 11, 12 auf.

Im folgenden wird als HS-Zweig (High Side) derjenige Viertelbrückenzweig bezeichnet, bei dem das Halbleiterbauelement 7 mit seiner Anode unmittelbar an die positive Versorgungsleitung 1 angeschlossen ist. Sinngemäss wird der andere Viertelbrückenzweig, bei dem das Halbleiterbauelement 8 mit seiner Kathode an die negative Versorgungsleitung gehängt ist, als LS-Zweig (Low Side) bezeichnet.

Gemäss einer bevorzugten Ausführungsform sind HS- und LS-Zweig je als separate Module (HS- und LS-Modul 5 resp. 6: Gehäuse mit elektrischen Anschlüssen) aufgebaut. In bezug auf die Bemessung der passiven Bauelemente und des konstruktiven Aufbaus wird auf die nicht vorveröffentlichte Schweizer Patentanmeldung CH-2106/90 verwiesen. Deren Inhalt soll als integrierter Bestandteil der vorliegenden Beschreibung gelten.

HS- und LS-Mudul 5, 6, d.h. die abschaltbaren Halbleiterbauelemente 7, 8 werden je durch eine Gate-Unit 13, 14 mit an sich bekannten Mitteln (z.B. MOSFET und Gate-Kondensator) angesteuert.

Gemäss einer bevorzugten Ausführungsform der Erfindung ist jeweils zwischen dem Mittelpunkt eines Moduls und dem gemeinsamen Lastanschluss 3 ein Messwiderstand R1, R2 vorgesehen. Die entsprechende Gate-Unit 13, 14 weist Mittel auf, um die am Messwiderstand R1, R2 anliegende Spannung, und damit den zur Last 4 fliessenden Strom zu messen. Wenn nun der gemessene Wert einen vorgegebenen Grenzwert (der z.B. in der Nähe des maximal abschaltbaren Stroms liegt) erreicht, dann blockiert die Gate-Unit 13 resp. 14 automatisch das Halbleiterbauelement 5 resp. 6.

Da kein Schaltstrom über den Messwiderstand R1 resp. R2 fliesst, treten keine die Detektionslogik verwirrende Spannungsspitzen auf. Infolgedessen kann zuverlässig auf äusseren Kurzschluss und auf Fehlzünden reagiert werden.

Entsprechend einer besonders vorteilhaften Asuführungsform ist zwischen dem Lastanschluss 3 und dem Mittelpunkt eines Moduls als strombegrenzendes Element eine kleine Induktivität L1, L2 angeordnet. Sie ist so in Serie zum genannten, jeweiligen Messwiderstand R1, R2 geschaltet, dass dieser zwischen Mittelpunkt und Induktivität zu liegen kommt, und kann gemäss der Erfindung mehrere Funktionen übernehmen.

Eine erste wichtige Funktion besteht in der Kurzschlussicherung. Wenn der Strom wegen eines Kurzschlusses stark ansteigt, dann muss dieser Fehler als erstes erkannt und dann das Halbleiterbauelement abgeschaltet werden. Sowohl die Detektion eines Kurzschlusses als auch das Abschalten brauchen eine gewisse Zeit. Ausgehend von der Grundlast (im einzelnen Halbleiterbauelement) darf der Strom in dieser Zeit nicht über den maximal abschaltbaren Grenzstrom steigen.

Die Grösse der Induktivität L1 resp. L2 muss für jeden Anwendungsfall separat berechnet werden. Wenn beispielsweise angenommen wird, dass ein Modul 200 A schaltet und etwa 2.5 kV sperrt, dann liegen die Werte typischerweise im Bereich von einigen $\mu$H.

Eine zweite Funktion der Induktivität L1 resp. L2 kann darin bestehen, dass sie zusammen mit einer im Lastkreis geeignet angeordneten Kapazität C ein Filter bildet, um die Last 4 (z.B. einen Motor) gegen Spannungstransiente abzuschirmen.

Als strombegrenzendes Element kann ausser einer Induktivität beispielsweise auch ein an sich bekanntes PTC-Element verwendet werden. Angestrebt ist dabei ein Verhältnis zwischen maximalem und minimalem Widerstand in der Grössenordnung von $10^4$ und mehr.

Die Stromdetektion bedingt nicht zwangsläufig einen separaten Messwiderstand. Vielmehr kann die Spannung auch gleich am PTC-Element abgegriffen werden.

Der mit dem PTC-Element implementierte Ueberstromschutz funktioniert im Prinzip wie folgt:

1. Wenn ein Lastkurzschluss oder ein Durchzünden auftritt, steigt der Strom stark an. Der FCTh vermag diesen Stromstoss ohne Schaden aufzunehmen (Stromstossfestigkeit aufgrund Diodenkennlinie).

2. Der PTC erwärmt sich und beginnt Spannung aufzunehmen.

3. Die Steuerlogik detektiert die Spannung am PTC, setzt z.B. ein internes Fehlerflag und wartet eine vorgegebene Zeit.

4. Der PTC erwärmt sich unterdessen weiter und beginnt den Strom unter den maximalen Abschaltstrom zu reduzieren.

5. Die vorgegebene Zeit läuft ab. Gemäss einer definierten Fehleranalyse gibt die Steuerlogik das Signal zum Abschalten des FCThs. Je nach Ausgestaltung der Fehleranalyse wird das Abschaltsignal erst dann ausgegeben, wenn eine Rückmeldung von der Stromerfassung via Messwiderstand erfolgt ist.

Der wesentliche Punkt bei diesem Schutzkonzept besteht darin, dass das abschaltbare Bauelement zwar kurzfristig den sehr grossen Strom aufnimmt, dass das Signal zum Abschalten aber erst dann ausgegeben wird, wenn das separate strombegrenzende Element den Strom unter den maximalen Abschaltstrom gedrückt hat.

Ebenso kann auch bei der Verwendung einer Induktivität als Strombegrenzung die Stromdetektion dadurch erfolgen, dass die Spannungsänderungen an der Induktivität gemessen und zeitlich aufintegriert werden. Auch in diesem Fall kann auf den separaten Messwiderstand verzichtet werden.

Von grossem Vorteil ist es, wenn im LS-Modul 6 ein abschaltbares Halbleiterbauelement 8 verwendet wird, das zu demjenigen des HS-Moduls 5 komplementär ist. Unter einem komplementären Bauelement ist dabei ein solches zu verstehen, bei dem das Gate anodenseitig angeordnet ist. Der Effekt dieser Massnahme besteht darin, dass die Gate-Units 13 und 14 der beiden Module im wesentlichen auf dem selben Potential wie die Messwiderstände R1 resp. R2 liegen. Damit ist es ohne aufwendige, zusätzliche Potentialtrennung in der Regelungsschaltung des Inverters und der Last möglich, den Laststrom zu jeder Zeit zu überwachen.

Ein besonders geeignetes Bauelementepaar ist in dieser Hinsicht die Kombination FCTh - CFCThs ([Complementary] Field Controlled Thyristor). Ein CFCTh (und ein FSGTO) ist z.B. in der Schweizer Patentanmeldung CH-1940/90-5 beschrieben. Das genannte Elementepaar hat weitgehend symmetrische elektrische Eigenschaften und vermag grosse Leistungen zu verarbeiten. Ausserdem können beide Elementtypen hart (d.h. ohne Snubber) angesteuert werden.

Als abschaltbare Halbleiterbauelemente eignen sich neben dem besonders bevorzugten FCThs resp. CFCThs im Prinzip alle schnellen, snubberfreien Schalter mit geringen Speicherzeiten (Schaltzeit < 200 ns). Dazu gehören z.B. der feinstrukturierte GTO (siehe Patentanmeldung CH-1940/90-50) oder - für kleinere Spannungen - der IGBT (Insulated Gate Bipolar Transistor).

Ein für die Praxis grosser Vorteil besteht darin, dass die den Inverter steuernde und die Last überwachende Antriebsregelung die in den Gate-Units 13, 14 vorhandene Strommessung auch für ihre eigenen Bedürfnisse verwenden kann. Für diesen Fall sind Mittel (Optokoppler, induktiver Koppler o.ä) vorzusehen, die dafür geeignet sind, die Messwerte von den Gate-Units 13, 14 an die zentrale Antriebsregelung zu übermitteln (z.B. via Pulsbreitenmodulation). Besonders schnelle Datenübertragung und -verarbeitung sind dabei nicht nötig, denn die Sicherungs-funktionen werden bereits vom Modul erfüllt. Die zentrale Antriebsregelung kann sich also auf die ihr eigenen Aufgaben konzentrieren.

Zusammenfassend zeichnet sich die Erfindung durch folgende Besonderheiten aus:

1. Stromtransiente in den Messwiderständen werden insbesondere durch die erfindungsgemässe Anordnung der Induktivitäten vermieden.

2. Die bevorzugten Induktivitäten begrenzen die Stromanstiegsgeschwindigkeit im Fehlerfall, ohne beim Normalbetrieb negativ Einfluss zu nehmen.

3. Auch beim Fehlzünden bzw. bei Defekt eines Leistungsschalters kann der Strom beim Einschalten des anderen nur so langsam ansteigen, dass genügend Zeit zur Schutzabschaltung bleibt. Eine gegenseitige Verriegelung kann deshalb entfallen ("Smart Power Hybrid").

4. Der Schutz ist auch bei Parallelschaltung von Viertelbrückenzweigen voll wirksam.

5. Aufgrund der einfachen Möglichkeit zur kontinuierlichen Stromerfassung in der Last (z.B. Motor) lassen sich auch hochdynamische Antriebe wirtschaftlich günstig herstellen.

Damit steht eine anwenderfreundliche Inverterschaltung zur Verfügung, die sich nach dem Baukastenprinzip realisieren lässt.

**Bezeichnungsliste**

1 - positive Versorgungsleitung; 2 - negative Versorgungsleitung; 3 - Lastanschluss; 4 - Last; 5 - HS-Modul; 6 - LS-Modul; 7, 8 - abschaltbares Halbleiterbauelement; 9, 10 - Freilaufdiode; 11, 12 - Abblock-Kondensator; 13. 14 - Gate-Unit; C - Kapazität; L1, L2 - Induktivität; R1, R2 - Messwiderstand.

**Patentansprüche**

1. Inverter mit Ueberstromschutz, bei welchem zwischen einer positiven und einer negativen Versorgungsleitung (1, 2) im Sinn einer Halbbrückenschaltung mindestens zwei abschaltbare Halbleiterbauelemente (7, 8) vorgesehen sind,
   dadurch gekennzeichnet, dass
   a) die Halbbrückenschaltung in zwei Viertelbrückenzweige aufgeteilt ist, in welchen dem Halbleiterbauelement (7, 8) bezüglich eines Mittelpunktes gegenüberliegend mindestens eine Freilaufdiode (9, 10) vorgesehen ist,
   b) zwischen einem Lastanschluss (3) und den Mittelpunkten jeweils ein strombegrenzendes Element (L1, L2) angeordnet ist und
   c) Mittel zum Messen des je vom Mittelpunkt zum Lastanschluss (3) fliessenden Stromes vorgesehen sind zwecks Durchzündschutz und Detektion eines Lastkurzschlusses.

2. Inverter nach Anspruch 1, dadurch gekennzeichnet, dass die abschaltbaren Halbleiterbauelemente (7, 8) in den Viertelbrückenzweigen komplementäre Halbleiterbauelemente sind.

3. Inverter nach Anspruch 1, dadurch gekennzeichnet, dass die abschaltbaren Halbleiterbauelemente niederinduktiv über je eine Gate-Unit (13, 14) angesteuert sind.

4. Inverter nach Anspruch 1, dadurch gekennzeichnet, dass die Mittel zum Messen des Stromes jeweils einen zwischen Mittelpunkt und strombegrendendem Element angeordneten Messwiderstand (R1, R2) umfassen

5. Inverter nach Anspruch 1, dadurch gekennzeichnet, dass für jedes Halbleiterbauelement (7, 8) eines Viertelbrückenzweiges eine separate Induktivität (L1, L2) vorgesehen ist.

6. Inverter nach Anspruch 1, dadurch gekennzeichnet, dass die Viertelbrückenzweige als getrennte LS- und HS-Module (5, 6) ausgebildet sind.

7. Inverter nach Anspruch 2, dadurch gekennzeichnet, dass die abschaltbaren Halbleiterbauelemente mindestens einen FCTh und einen CFCTh umfassen, wobei der FCTh in einem als HS-Zweig ausgebildeten Viertelbrückenzweig mit seiner Anode direkt an die positive Versorgungsleitung (1) und der CFCTh in einem als LS-Zweig ausgebildeten Viertelbrückenzweig mit seiner Kathode direkt an die negative Versorgungsleitung (2) angeschlossen ist.

8. Inverter nach Anspruch 1, dadurch gekennzeichnet, dass die strombegrenzenden Elemente entweder eine die Stromanstiegsgeschwindigkeit begrenzende Induktivität (L1, L2) oder ein PTC-Element umfassen.

9. Inverter nach Anspruch 1, dadurch gekennzeichnet, dass in den Viertelbrückenzweigen
   a) parallel zur Serieschaltung von Halbleiterbauelement (7, 8) und Freilaufdiode (9, 10) ein niederinduktiver Abblockkondensator (11, 12) zum Auffangen der Reverse Recovery Stromspitzen der Freilaufdiode (9, 10) vorgesehen ist,
   b) Freilaufdiode (9, 10) und Abblockkondensator (11, 12) niederinduktiv und räumlich unmittelbar neben dem Halbleiterbauelement (7, 8) angeordnet sind und
   c) von einer Gate-Unit (13, 14) angesteuert werden.

10. Inverter nach Anspruch 8, dadurch gekennzeichnet, dass die strombegrenzenden Elemente Induktivitäten (L1, L2) sind, die Teil eines Filters (C) zur Dämpfung des Spannungsanstiegs im Lastkreis sind.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | INTELEC '87, CONFERENCE PROCEEDINGS, Stockholm, 14. - 17. Juni 1987, Seiten 531-534; J. GALIC et al.: "The application of GTO's to convertors for UPS-systems" * Seite 531, linke Spalte, Zeile 20 - rechte Spalte, Zeile 9; Figur 1 * – – – | 1,5,8 | H 03 K 17/08 H 02 M 7/515 |
| A | ETZ ELEKTROTECHNISCHES ZEITSCHRIFT, Band 110, Nr. 10, Mai 1989, Seiten 464-471; W. BÖSTERING et al.: "IGBT-Module in Stromrichtern: regeln, steuern, schützen" * Seite 470, linke Spalte, Zeile 16; Figuren 2,7 * – – – | 1,4 | |
| A | REVUE GENERALE DE L'ELECTRICITE, Nr. 2, Februar 1986, Seiten 19-22; G. MOURIES: "Evolution des condensateurs de puissance secs" * Seite 22, linke Spalte, Zeilen 5-21; Figur 7 * – – – | 3,9 | |
| A | EP-A-0 185 181  (BBC AG) * Seite 4, Zeile 21 - Seite 7, Zeile 12; Figuren 1-4 * – – – | 3,9 | |
| A | 19TH ANNUAL IEEE POWER ELECTRONICS SPECIALISTS CONFERENCE, Kyoto, 11.-14. April 1988, Band 2, Seiten 1311-1318; H. GRUENING et al.: "Field controlled thyristors - A new family of power semiconductors with advanced circuitry" * Seite 1314, linke Spalte, Zeilen 14-21; Figur 10 * – – – – – | 7 | **RECHERCHIERTE SACHGEBIETE (Int. Cl.5)** H 03 K H 02 M |

Der vorliegende Recherchenbericht wurde für alle Patentansprüche erstellt

| Recherchenort | Abschlußdatum der Recherche | Prüfer |
|---|---|---|
| Den Haag | 28 März 91 | CANTARELLI R.J.H. |